(19) Europäisches Patentamt / European Patent Office / Office européen des brevets

(11) **EP 2 568 778 A1**

(12) # EUROPEAN PATENT APPLICATION
published in accordance with Art. 153(4) EPC

(43) Date of publication:
**13.03.2013 Bulletin 2013/11**

(21) Application number: **12744295.2**

(22) Date of filing: **09.02.2012**

(51) Int Cl.:
*H05K 1/09* (2006.01)    *C08K 3/08* (2006.01)
*C08K 9/02* (2006.01)    *C08L 21/00* (2006.01)
*H02N 2/00* (2006.01)

(86) International application number:
**PCT/JP2012/052974**

(87) International publication number:
**WO 2012/108502 (16.08.2012 Gazette 2012/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.02.2011 JP 2011027125**

(71) Applicant: **Tokai Rubber Industries, Ltd.**
**Komaki-shi, Aichi 485-8550 (JP)**

(72) Inventors:
• **TAGUCHI, Yutaro**
**Komaki-shi, Aichi 485-8550 (JP)**
• **TAKAHASHI, Wataru**
**Komaki-shi, Aichi 485-8550 (JP)**
• **YOSHIKAWA, Hitoshi**
**Komaki-shi, Aichi 485-8550 (JP)**
• **KOBAYASHI, Jun**
**Komaki-shi, Aichi 485-8550 (JP)**

(74) Representative: **Müller-Boré & Partner**
**Patentanwälte**
**Grafinger Straße 2**
**81671 München (DE)**

(54) **FLEXIBLE CONDUCTIVE MATERIAL, METHOD FOR MANUFACTURING SAME, AND ELECTRODE, WIRING, ELECTROMAGNETIC WAVE SHIELDING, AND TRANSDUCER USING FLEXIBLE CONDUCTIVE MATERIAL**

(57) A flexible conductive material of the present invention includes an elastomer and a conductive material including silver at least in a surface. The conductive material is chemically bonded to the elastomer directly or indirectly and is thus incorporated into a mesh structure of the elastomer. Volume resistivity is $1 \times 10^{-2}$ $\Omega \cdot cm$ or less in a state where the flexible conductive material is expanded by 10% in one axis direction. The flexible conductive material of the present invention is flexible and expandable/contractable and hardly increases in electrical resistance even after repeated expansion and contraction. A method of manufacturing the flexible conductive material of the present invention includes preparing a rubber composition including a rubber polymer composed of the elastomer component, the conductive material, and a reactive compound capable of being chemically bonded to both the elastomer and the conductive material and mixed when necessary; and cross-linking the prepared rubber composition.

Fig. 1
(a) Voltage turned off
(b) Voltage turned on

EP 2 568 778 A1

**Description**

[Technical Field]

The present invention relates to an expandable/contractable flexible conductive material, a method of manufacturing the same, and an electrode, a wiring, an electromagnetic wave shield, and a transducer using the flexible conductive material.

[Background Art]

Highly flexible, compact, and lightweight transducers have been developed using polymer materials, such as an elastomer. Transducers are devices that perform conversion between mechanical energy and electrical energy, including an actuator, a sensor, and a power generation element, or devices that perform conversion between acoustic energy and electrical energy, including a speaker and a microphone. For instance, an actuator can be configured in which a pair of electrodes is disposed on front and rear surfaces of an elastomer dielectric film. In such an actuator, the dielectric film expands and contracts depending on a level of applied voltage. In order to prevent interference with expansion and contraction of the dielectric film, the electrodes are required to be expandable and contractable in accordance with deformation of the dielectric film. In addition, a variation in electrical resistance is required to be small when expanded.

A conductive adhesive agent is used to connect terminals of a circuit board or to connect an electronic component. When connecting a flexible device, such as a flexible printed wiring board (FPC), strain and stress due to expansion and contraction are exerted on the conductive adhesive agent. In view of reliability and durability in a connection portion, the conductive adhesive agent is thus also required to be flexible. Furthermore, with an increasing level of digitization, high frequencies, and size reduction of electronic components, it is important to develop an electromagnetic wave shield to shield against unwanted electromagnetic waves. The electromagnetic wave shield is also frequently required to be flexible for use as a flexible and expandable/contractable wiring of an electronic component.

As a flexible and expandable/contractable conductive material, Patent Literature 1 discloses an electrode composed of a paste including a conductive material, such as carbon black, mixed with an oil and an elastomer. Patent Literature 2 discloses a conductive film including an elastomer and two kinds of metal fillers having different shapes.

[Citation List]

[Patent Literature]

Patent Literature 1: Japanese Patent Laid-Open Publication No. 2009-124839
Patent Literature 2: Japanese Patent Laid-Open Publication No. 2010-153364
Patent Literature 3: Japanese Patent Laid-Open Publication No. 2007-73267

[Summary of Invention]

[Technical Problem]

Conventional conductive materials, however, increase in electrical resistance due to repeated expansion and contraction. Thus, with an electrode or a wiring formed of a conventional conductive material, a device is likely to be degraded by increased electrical resistance in the electrode or the wiring due to repeated expansion and contraction. With high electrical resistance in the electrode or the wiring, responsiveness of an actuator or an acoustic device may decline since a reactance component is generated in a high frequency range. Furthermore, excessively high electrical resistance to detection signals may reduce resolution performance of a sensor.

A conventional conductive material used as a conductive adhesive agent may affect device performance due to a decrease in conductivity in the course of repeated expansion and contraction. Furthermore, a conventional conductive material used as an electromagnetic wave shield may decrease in shielding performance due to a decrease in conductivity.

In view of the circumstances above, an object of the present invention is to provide a flexible conductive material and a method of manufacturing the same, the flexible conductive material being flexible and expandable/contractable and hardly increasing in electrical resistance even after repeated expansion and contraction. Another object is to provide an electrode, a wiring, and an electromagnetic wave shield that hardly increase electrical resistance even after repeated expansion and contraction. Another object is to provide a flexible transducer excellent in durability.

[Solution to Problem]

(1) To address the circumstances above, a flexible conductive material according to the present invention includes an elastomer and a conductive material including silver at least in a surface. The conductive material is chemically bonded to the elastomer directly or indirectly and is thus incorporated into a mesh structure of the elastomer. Volume resistivity in a case of expansion by 10% in one axis direction is $1 \times 10^{-2}$ $\Omega \cdot$cm or less.

After diligent study of conventional conductive materials, the inventors of the present invention have found that an increase in electrical resistance due to repeated expansion and contraction stems from peeling of an elastomer base material from a conductive material or a change in a form of a conductive path due to movement of the conductive material. To inhibit the conductive material from peeling or moving, the elastomer and the conductive material can be chemically bonded to each other. Such a conductive material, however, exhibits conductivity through contact of the conductive material with another conductive material and flow of electrons between the materials. Thus, chemically bonding an organic material, which is an insulating material, to a surface of the conductive material may decrease conductivity.

In this regard, the flexible conductive material of the present invention chemically bonds the elastomer and the conductive material while maintaining necessary conductivity. Specifically, in the flexible conductive material of the present invention, the conductive material is chemically bonded to the elastomer directly or indirectly and is thus incorporated into the mesh structure of the elastomer. To be "chemically bonded ... directly" means that the conductive material is chemically bonded directly to a molecular chain of the elastomer. To be "chemically bonded ... indirectly" means that the conductive material is chemically bonded through another material. The elastomer may or may not be cross-linked. Thus, peeling of the conductive material from the elastomer or movement of the conductive material is inhibited even in a case of repeated expansion and contraction. Accordingly, an increase in the electrical resistance is inhibited. The flexible conductive material of the present invention has a volume resistivity of $1 \times 10^{-2}$ $\Omega \cdot$cm or less in a case of expansion by 10% in one axis direction. In other words, the conductivity is maintained by controlling a chemical reaction amount in the surface of the conductive material so as not to interfere with an exchange of electrons between the conductive materials. Thus, the flexible conductive material of the present invention satisfies two contradictory demands: maintaining the necessary conductivity for the conductive material and inhibiting a reduction in the conductivity due to repeated expansion and contraction.

Patent Literature 3 discloses a conductive film that includes silver powder and a triazine thiol derivative. In the conductive film, the triazine thiol derivative forms a complex with the silver powder. This improves sulfur resistance of the conductive film. Patent Literature 3 recites that the conductive film may include an organic material, such as a binder resin, in addition to the silver power and the triazine thiol derivative. Patent Literature 3, however, does not include a concept of forming an expandable and contractable conductive film. Thus, there is no description regarding the issue of an increase in electrical resistance due to repeated expansion and contraction nor regarding bonding between the silver powder and the binder resin.

(2) A method of manufacturing the flexible conductive material according to the present invention, which is an aspect of a method of manufacturing the flexible conductive material according to the present invention above, includes preparing a rubber composition including a rubber polymer composed of the elastomer component, the conductive material, and a reactive compound capable of being chemically bonded to both the elastomer and the conductive material and mixed when necessary; and cross-linking the prepared rubber composition.

The reactive compound can be chemically bonded to both the elastomer and the conductive material. Thus, adding the reactive compound allows indirect chemical bonding of the elastomer and the conductive material through the reactive compound. In a case where the elastomer is chemically bonded directly to the conductive material, such as in a case where the elastomer has a functional group capable of being chemically bonded to the conductive material, for instance, adding the reactive compound is not necessarily required.

In the preparing of the rubber composition, a composition amount, a number of functional groups of the elastomer, or a composition amount of the reactive compound is adjusted to control a chemical reaction amount in the surface of the conductive material. This controls the conductivity of the flexible conductive material to be produced.

Cross-linking the prepared rubber composition forms a mesh structure in the elastomer. The conductive material is incorporated into the mesh structure of the elastomer by being chemically bonded to the elastomer directly or indirectly. Thus, the manufacturing method of the present invention allows easy manufacturing of the flexible conductive material of the present invention.

(3) An electrode according to the present invention is composed of the flexible conductive material according to the present invention above. Thus, the electrode of the present invention is expandable and contractable. In addition, the electrical resistance hardly increases even after repeated expansion and contraction. Thus, a decrease in device performance due to an increase in the electrical resistance of the electrode is limited at the time of use.

(4) A wiring according to the present invention is composed of the flexible conductive material according to the present invention above. Thus, the wiring of the present invention is expandable and contractable. In addition, the electrical resistance hardly increases even after repeated expansion and contraction. Thus, a decrease in device performance due to an increase in the electrical resistance of the wiring is limited at the time of use.

(5) An electromagnetic wave shield according to the present invention is composed of the flexible conductive material according to the present invention above. The electromagnetic wave shield of the present invention can be formed of, for example, a conductive coating material, which is composed of raw materials included in the flexible conductive material of the present invention, such as the rubber polymer and the conductive material, dissolved in a solvent,. Alternatively, without using the solvent, a kneaded material formed of kneaded raw materials may be press-molded or extrusion-molded for forming. Thus, with limited restriction on shape, the electromagnetic wave shield is readily placed in various portions to be shielded from electromagnetic waves. In addition, the electromagnetic wave shield of the present invention is expandable and contractable, and thus hardly increases in electrical resistance even after repeated expansion and contraction. Accordingly, the electromagnetic wave shield hardly decreases in shielding performance even when used for an expandable and contractable member.

The flexible conductive material of the present invention hardly increases in electrical resistance even after repeated expansion and contraction. Thus, it is suitable as a conductive adhesive agent to electrically connect expandable and contractable members.

(6) A transducer according to the present invention includes a dielectric film composed of one of an elastomer and a resin; a plurality of electrodes disposed with the dielectric film therebetween; and a wiring connected to each of the plurality of electrodes. At least one of the electrodes and the wirings includes the flexible conductive material according to the present invention above.

A transducer is a device that converts a certain type of energy into another type of energy. As described above, examples of the transducer include an actuator, a sensor, or a power generation element, which performs conversion between mechanical energy and electrical energy; and a speaker or a microphone, which performs conversion between acoustic energy and electrical energy. According to the transducer of the present invention, at least one of the electrodes and the wirings are composed of the flexible conductive material of the present invention above. The electrodes and the wirings formed of the flexible conductive material of the present invention are expandable and contractable. Thus, the movement of the transducer is hardly interfered with by the electrodes and the wirings. The electrodes and the wirings formed of the flexible conductive material of the present invention hardly increase in electrical resistance even after repeated expansion and contraction. Thus, a decrease in the transducer's performance due to an increase in the electrical resistance of the electrodes and the wirings is limited at the time of use. Accordingly, the transducer of the present invention has excellent durability.

[Brief Description of Drawings]

[Fig. 1] Schematic cross-sectional views of an actuator, which is a transducer according to a first embodiment of the present invention, in which (a) illustrates a state where voltage is turned off and (b) illustrates a state where voltage is turned on.

[Fig. 2] A top view of a capacitance sensor, which is a transducer according to a second embodiment of the present invention.

[Fig. 3] A cross-sectional view along a line III - III of Fig. 2.

[Fig. 4] Schematic cross-sectional views of a power generating element, which is a transducer according to a third embodiment of the present invention, in which (a) illustrates a time of expansion and (b) illustrates a time of contraction.

[Fig. 5] A perspective view of a speaker, which is a transducer according to a fourth embodiment of the present invention.

[Fig. 6] A cross-sectional view along a line VI - VI of Fig. 5.

[Reference Signs List]

1: Actuator (transducer); 10: Dielectric film; 11a, 11b: Electrode; 12a, 12b: Wiring; 13: Power source

2: Capacitance sensor (transducer); 20: Dielectric film; 21a, 21b: Electrode; 22a, 22b: Wiring; 23a, 23b: Cover film; 24: Connector

3: Power generating element (transducer); 30: Dielectric film; 31a, 31b: Electrode; 32a - 32c: Wiring

4: Speaker (transducer); 40a: First outer frame; 40b: Second outer frame; 41a: First inner frame; 41b: Second inner frame; 42a: First dielectric film; 42b: Second dielectric film; 43a: First outer electrode; 43b: Second outer electrode; 44a: First inner electrode; 44b: Second inner electrode; 45a: First diaphragm; 45b: Second diaphragm; 430a, 430b, 440a, 440b: Terminal; 460: Bolt; 461: Nut; 462: Spacer

[Description of Embodiments]

Embodiments according to the present invention are described below with respect to a flexible conductive material, a method of manufacturing the same, an electrode, a wiring, an electromagnetic wave shield, and a transducer. The flexible conductive material, the method of manufacturing the same, the electrode, the wiring, the electromagnetic wave shield, and the transducer according to the present invention are not limited to the embodiments below, and may be embodied in various ways in which modifications and improvements could be performed by persons skilled in the art without deviating from the concept of the present invention.

<Flexible Conductive Material>

The flexible conductive material according to the present invention includes an elastomer and a conductive material. The conductive material has silver (Ag) at least in a surface thereof. The conductive material may be composed of silver powder or a particulate powder whose surface is coated with silver. Examples of coated particles may include metals, such as copper; carbon materials, such as graphite and carbon black; metal oxides, such as calcium carbonate, titanium dioxide, aluminum oxide, and barium titanate; inorganic materials, such as silica; and resins, such as acrylic and urethane. The powder for the conductive material may be of one kind or more than one kind.

A size and shape of the conductive material is not particularly limited. For example, using two or more conductive materials having different shapes and sizes readily forms a flexible conductive material having a limited reduction in conductivity even when expanded. In this case, it is preferred to combine particles having a relatively large aspect ratio, such as a flake shape and a needle shape, and particles having a relatively small aspect ratio, such as a spherical shape. In particular, the particles having a relatively large aspect ratio preferably have an aspect ratio of 10 or greater and a thickness of 0.5 $\mu$m or less.

A content of the conductive material in the flexible conductive material of the present invention may be determined such that predetermined conductivity is achieved. In view of improvement in flexibility of the flexible conductive material, for instance, it is desirable that the content of the conductive material be 45 vol % or less relative to a volume of the flexible conductive material of 100 vol %. The content is preferably 25 vol % or less, and more preferably 15 vol % or less.

Any elastomer having rubber-like elasticity at room temperature is acceptable. For example, an elastomer having a glass-transition temperature (Tg) of 0°C or less is preferred due to its flexibility. Crystallinity reduces as the Tg lowers, and thus breaking extension of the elastomer increases. In other words, the elastomer easily stretches. In addition, increased viscosity of the elastomer provides the flexible conductive material with adherence properties. The adherence properties in the flexible conductive material improve adhesiveness to a base material. For example, in a case where the flexible conductive material is disposed on a surface of an elastic member, when adhesiveness of the flexible conductive material is insufficient, the flexible conductive material peels off from the elastic member due to repeated strain exerted thereon, thus possibly reducing mechanical reliability and electrical reliability. In addition, a void generated between the elastic member and the flexible conductive member may lead to insulation breakdown. Thus, the Tg of the elastomer is preferably -20°C or less, and more preferably -35°C or less. In the present specification, an intermediate glass-transition temperature, which is measured in accordance with JIS K7121 (1987), is employed as the glass-transition temperature.

The elastomer may be of a single kind or a mixture of two or more kinds. Examples of preferred elastomers may include acrylic rubber, urethane rubber, hydrin rubber, acrylonitrile-butadiene rubber (NBR), silicone rubber, natural rubber, isoprene rubber, butyl rubber, styrene-propylene rubber, fluorine-containing rubber, butadiene rubber, chloroprene rubber, epichlorohydrin rubber, chlorosulfonated polyethylene, chlorinated polyethylene, and a thermoplastic elastomer. In particular, the acrylic rubber has low crystallinity and low intermolecular force, and thus has a low Tg compared to other rubber. Thus, the acrylic rubber, which has flexibility and good expandability, is preferred as an electrode of an actuator. The acrylic rubber preferably includes an acrylic acid ester monomer unit of 50 mol % or greater, the acrylic acid ester monomer including an alkyl group having a carbon number of four or greater. A large alkyl group (a large carbon number) reduces crystallinity and thus further reduces the elasticity modulus of the acrylic rubber.

In addition to the elastomer and the conductive material, the flexible conductive material of the present invention preferably includes a reactive compound capable of being chemically bonded to both the elastomer and the conductive material. With respect to the conductive material, the reactive compound should be capable of chemically bonding to the silver in the surface. With the reactive compound included, the elastomer and the conductive material are chemically bonded indirectly through the reactive compound. Thus, even in a case where the elastomer and the conductive material are not chemically bonded directly to each other, the conductive material can be incorporated into a mesh structure of the elastomer.

The reactive compound is preferably a sulfur compound which is highly reactive to silver. Specifically, examples of the reactive compound may include mercaptopropylmethoxysilane, mercaptopropylethoxysilane, trimercaptotriazine, mercaptobenzimidazole, sodium mercaptobenzimidazole sulfonate, mercaptobenzthiazole, mercaptobenzthiazole cycloalkylamine, mercaptobutanol, mercaptobutanone, mercaptoethanol, mercaptoethyl sulfide, mercaptohexanol, mercaptopentanone, mercaptopropanediol, chloroacetonitrile, chlorobenzonitrile, chlorobenzylamine, and chloroethoxyethanol.

In addition to bonding between the elastomer and the conductive material, there is a case where the reactive compound is also associated with cross-linking of the elastomer. In this case, the bonding reaction between the elastomer and the conductive material and the cross-linking reaction of the elastomer are competitive reactions. Thus, in the case where the reactive compound is also associated with cross-linking of the elastomer, a composition amount of the reactive compound needs to be determined in consideration of an amount consumed in the cross-linking reaction of the elastomer. In view of easy control of a chemical reaction amount, specifically coverage (described hereinafter), in the surface of the conductive material, the reactive compound is preferably a compound not associated with cross-linking of the elastomer.

In a case where the elastomer has a functional group capable of being chemically bonded to the conductive material, it is unnecessary to use the reactive compound to bond the elastomer and the conductive material. The functional group herein should be capable of chemically bonding to the silver in the surface of the conductive material. In this case, the elastomer and the conductive material are chemically bonded directly to each other. The functional group preferably includes at least one kind selected from a fluorine atom, a chlorine atom, and a sulfur atom. Examples of such a functional group may include a halogen (-F, -Cl and the like) and a mercapto group (-SH). Examples of such an elastomer may include epichlorohydrin rubber, chloroprene rubber, fluorine-containing rubber, chlorosulfonated polyethylene, and chlorinated polyethylene.

In the flexible conductive material of the present invention, the conductive material is chemically bonded to the elastomer directly or indirectly, and is thus incorporated into the mesh structure of the elastomer. Whether or not the conductive material is incorporated into the mesh structure of the elastomer can be determined in two methods described below.

(1) Dynamic Viscoelastic Test

Dynamic viscoelasticity is measured in a temperature range from -30°C to 80°C in a case where tensile strain is applied to a flexible conductive material with a dynamic viscoelastic measurement device (UBM "Rheogel-E4000"). Then, a loss elastic modulus (E"), a storage elastic modulus (E'), and a loss coefficient (tan $\delta$) are obtained at each temperature.

When an elastomer and a conductive material are chemically bonded to each other, the movement of the elastomer is restricted. Compared to a case of no chemical bonding, the loss elastic modulus is small and the tan $\delta$ is small. In the present specification, the conductive material is determined to be incorporated into the mesh structure of the elastomer when a peak value of the tan $\delta$ is reduced by 0.05 or greater compared with a case of a conventional conductive material in which an elastomer and a conductive material are not chemically bonded to each other.

(2) X-Ray Photoelectron Spectroscopy Test

A surface and an etched interior of a flexible conductive material are measured with X-ray photoelectron spectroscopy to obtain a spectrum. A peak position of the spectrum is different for Ag and AgX (X being an atom included in an elastomer or a reactive compound). When silver in a conductive material chemically reacts with an elastomer or a reactive compound, an AgX peak appears; otherwise, an Ag peak appears. In the present specification, the conductive material is thus determined to be incorporated into the mesh structure of the elastomer when the AgX peak appears.

In the flexible conductive material of the present invention, the conductive material comes into contact with another conductive material and electrons flow between the materials, thus exhibiting conductivity. In order to achieve desired conductivity, it is thus necessary to control a chemical reaction amount in the surface of the conductive material. Specifically, it is necessary to control coverage of the surface of the conductive material. The coverage is calculated in the following formula (I):

$$\text{Coverage (\%)} = \text{Covered area / Surface area of conductive material} \times 100 \ ... \ (I)$$

The covered area in the formula (I) refers to an area on the surface of the conductive material covered by at least one of the elastomer and the reactive compound. For instance, the area covered by the reactive compound is calculated as described below.

First, the conductive material and a predetermined amount of the reactive compound are mixed and reacted with each other. At this time, the conductive material may be mixed into a solution in which the reactive compound is dissolved. Then, elemental mapping of the reacted conductive material is performed with an Auger electron spectrometer. The results are binarized and an area is calculated to obtain a covered area. In a case where a particle size of the conductive material used is so small as to be close to the resolution performance of the Auger electron spectrometer, the accuracy of the elemental mapping may decline. In this case, the covered area may be obtained by substituting a conductive material having a large particle size and having a surface composition as similar as possible to the conductive material used.

A relationship between the composition amount of the reactive compound and the covered area are thus obtained. Then, the composition amount of the reactive compound for the target coverage can be determined from the formula (I) above. The composition amount of the elastomer can be determined in the same manner. In the case of the elastomer, reactivity to the conductive material changes depending on the number of functional groups. For example, the number of functional groups that react with the conductive material can be reduced by allowing the elastomer to react with another compound in advance. Thus, even with use of the same amount of elastomer, the coverage can be reduced. Examples of compounds that react with a halogen may include a mercapto compound, an amino compound, an olefin compound, a phenol resin, an epoxy resin, and a polyamine. The number of functional groups of these compounds is preferably controlled so as not to excessively cross-link with the elastomer.

The greater the coverage is, the larger the area covered by an insulating substance is on the surface of the conductive material. This interferes with an exchange of electrons between the conductive materials, and thus reduces the conductivity of the flexible conductive material. Furthermore, an increase in electrical resistance is greater when the flexible conductive material is expanded. Meanwhile, with an excessively small coverage, the conductive material cannot be sufficiently incorporated into the mesh structure of the elastomer. As a result, the increase in the electrical resistance becomes greater in the course of repeated expansion and contraction. In order to achieve desired conductivity, an optimum coverage must be obtained.

In view of the above, the coverage is preferably defined at 0.5% or greater and 40% or less, for example. The coverage is preferably 30% or less, and more preferably 20% or less. However, the relationship between the conductivity and the coverage of the flexible conductive material is determined by various factors, including the composition amount, size, and shape of the conductive material, and kinds of the elastomer and the reactive compound. Thus, the coverage may be determined appropriately so as to achieve desired conductivity depending on the conductive material, elastomer, and reactive compound used.

Conductivity at the time of expansion is particularly important as an index of conductivity. With low conductivity at the time of expansion, a decrease in conductivity becomes greater in the course of repeated expansion and contraction. With a large coverage, the conductivity is observed to decrease substantially at the time of expansion even when the conductivity is high at the time of non-expansion (natural state). This is because the large coverage reduces a contact area in the surfaces of the conductive materials themselves, and thus a conductive path is easily disconnected due to expansion. Whether or not the coverage is appropriate can be determined by the conductivity at the time of expansion. Specifically, this is determined based on whether volume resistivity is $1 \times 10^{-2}$ $\Omega \cdot$cm or less in a case where the flexible conductive material is expanded by 10% in one axis direction. The coverage is thus determined to be appropriate when the volume resistivity is $1 \times 10^{-2}$ $\Omega \cdot$cm or less when expanded by 10%. The volume resistivity is more preferably $1 \times 10^{-2}$ $\Omega \cdot$cm or less when expanded by 50% in one axis direction. In addition, in comparison between the time of non-expansion and the time of expansion by 10%, a change in the volume resistivity is preferably within 100 fold. The volume resistivity can be measured in accordance with a parallel plate electrode method defined in JIS K6271 (2008).

In addition to the elastomer, the conductive material, and the reactive compound, the flexible conductive material of the present invention may include additives, such as a plasticizer, a processing aid, a cross-linker, a cross-linking promoter, a cross-linking aid, an antioxidant, a softener, and a colorant. Adding the plasticizer and the softener, for instance, improves processability of the elastomer and further improves flexibility. Any plasticizer having good compatibility with the elastomer may be employed. Examples may include publicly-known organic acid derivatives, such as a phthalic acid diester; phosphoric acid derivatives, such as a tricresyl phosphate; an adipic acid diester; a chlorinated paraffin; and a polyether-ester. The softener may be a plant-based softener or a mineral-based softener. Examples of the plant-based softener may include stearic acid, lauric acid, ricinolic acid, palmitic acid, cottonseed oil, soybean oil, castor oil, palm oil, pine tar oil, tall oil, and factice. Examples of the mineral-based softener may include paraffinic oil, naphthenic oil, and aromatic oil.

The cross-linker, the cross-linking promoter, and the cross-linking aid to cross-link the elastomer (hereinafter collectively referred to as an elastomer cross-linker) may be determined appropriately depending on a type of the elastomer. In a case where the elastomer cross-linker is also chemically bonded to the conductive material, it is necessary to control a reaction with the conductive material in addition to the cross-linking reaction of the elastomer. Thus, use of an elastomer cross-linker not chemically bonded to the conductive material is desirable.

Using an organic peroxide for the elastomer cross-linker may oxidize the conductive material. This may increase the electrical resistance in the surface of the conductive material, and thus decreases the conductivity of the flexible conductive material. Use of an organic peroxide for the elastomer cross-linker is thus not desirable. In this case, the elastomer can be at least one kind selected from a cross-linked rubber that is cross-linked with no organic peroxide and a thermoplastic elastomer.

The flexible conductive material of the present invention can be formed on surfaces of various base materials depending on purposes. The base material may be a flexible resin film formed of, for example, polyimide, polyethylene, polyethylene terephthalate (PET), and polyethylene naphthalate (PEN). The flexible conductive material of the present invention formed on a surface of an elastomer elastic member can further exhibit effects of having high flexibility and inhibiting an increase in electrical resistance even after repeated expansion and contraction. Examples of such an elastic member may include a dielectric film in a transducer and a base material in a flexible wiring board.

In order to inhibit corrosion of the conductive material, the elastic member preferably includes none of sulfur, a sulfur compound, and an organic peroxide. In this case, the elastomer for the elastic member can be at least one kind selected from a cross-linked rubber that is cross-linked with no sulfur, sulfur compound, or organic peroxide, and a thermoplastic elastomer. The elastomer of the elastic member may be the same elastomer of the flexible conductive material or a different elastomer.

<Method of Manufacturing Flexible Conductive Material>

A method of manufacturing the flexible conductive material of the present invention includes a process of preparing a rubber composition and a cross-linking process. Each process is described below.

(1) Process of Preparing Rubber Composition

In this process, a rubber composition is prepared that includes a rubber polymer having an elastomer component, a conductive member, and a reactive compound capable of being chemically bonded to both the elastomer and the conductive material and mixed in when necessary.

The rubber composition can be prepared by, for example, mixing the rubber polymer and the conductive material (including an additive as desired) and kneading the mixture to which the reactive compound is added when necessary with a kneader, a pressure kneader, such as a Banbury mixer, or a two-roll machine. Alternatively, a solvent may be added to the mixture and kneaded to prepare a conductive coating material.

In this process, the coverage of the surface of the conductive material is controlled by adjusting the composition amount of the elastomer, the number of functional groups, and the composition amount of the reactive compound. This controls the conductivity of the flexible conductive material to be produced.

When the reactive compound is mixed, the reactive compound is sometimes involved in cross-linking of the elastomer, in addition to bonding between the elastomer and the conductive material. In this case, the reaction that bonds the elastomer and the conductive material and the cross-linking reaction of the elastomer are competitive reactions. Thus, controlling the coverage of the surface of the conductive material is difficult. In this case, this process may be configured to include a pre-treatment process in which the conductive material and the reactive compound react with each other in advance and a mixing process in which the chemically bonded conductive material and reactive compound are mixed into the rubber polymer.

In the present configuration, the conductive material and the reactive compound react with each other in advance in the pre-treatment process. Thus, the conductive material and the reactive compound are chemically bonded to each other and the surface of the conductive material is covered at a predetermined coverage. Accordingly, the conductive material and the reactive compound can react with each other without being affected by the cross-linking reaction of the elastomer. In other words, the coverage can be controlled regardless of the cross-linking reaction of the elastomer. According to the present configuration, the coverage of the surface of the conductive material is easily controlled even in the case where the reactive compound is associated with the cross-linking of the elastomer.

(2) Cross-linking Process

In this process, the prepared rubber composition is cross-linked. Thereby, a mesh structure of the elastomer is formed and the conductive material is chemically bonded directly to the elastomer or indirectly through the reactive compound and is thus incorporated into the mesh structure of the elastomer.

In a case where the rubber composition is a kneaded material, for example, the kneaded material is pressurized and heated by metal molding or extrusion molding to advance the cross-linking reaction. In a case where the rubber composition is a conductive coating material, the conductive coating material is coated on a base material and, through heating, is dried and the cross-linking reaction is advanced. The conductive coating material may be coated in various publicly-known methods. Examples include printing methods, such as ink-jet printing, flexography, gravure printing, screen printing, pad printing, and lithography; a dip method; a spray method; and a bar-coating method. Employing a printing method allows easy separation of a portion to be coated from a portion to not be coated, for example. It is also easy to print a large area, a fine line, and a complex shape. Screen printing is suitable among the printing methods because it allows use of a high-viscosity coating material, easy control over thickness of a coating film, and formation of a thick film.

<Electrode, Wiring, and Transducer>

A transducer of the present invention has a dielectric film including an elastomer or a resin, a plurality of electrodes disposed with the dielectric film therebetween, and a wiring connected to each of the plurality of electrodes. The dielectric film is composed of an elastomer or a resin. Use of the elastomer, which has high relative permittivity, is particularly desirable. Specifically, a desirable elastomer has a relative permittivity (100 Hz) of 2 or greater, more preferably 5 or greater, at an ambient temperature. Examples of such an elastomer may include an elastomer having a polar functional group, such as an ester group, a carboxyl group, a hydroxyl group, a halogen group, an amide group, a sulfone group, a urethane group, or a nitrile group; and an elastomer to which a polar low-molecular-weight compound having the polar functional group is added. Examples of a preferred elastomer may include silicone rubber, acrylonitrile-butadiene rubber (NBR), hydrogenated acrylonitrile-butadiene rubber (H-NBR), ethylene-propylene-diene rubber (EPDM), acrylic rubber, urethane rubber, epichlorohydrin rubber, chlorosulfonated polyethylene, and chlorinated polyethylene. The phrase "including an elastomer or a resin" means that a base material of the dielectric film is an elastomer or a resin. In addition to the elastomer or the resin component, other components, including an additive, may be included.

The thickness of the dielectric film can be determined appropriately depending on a purpose of the transducer. In a case of an actuator, for instance, the dielectric film is preferably thin in view of size reduction, low voltage drive, and increased displacement. In this case, the thickness of the dielectric film is preferably 1 $\mu$m or greater and 1,000 $\mu$m (1 mm) or less in consideration of insulation breakdown as well. More preferred is 5 $\mu$m or greater and 200 $\mu$m or less.

At least one of the electrodes and the wirings are formed of the flexible conductive material of the present invention. The configuration of the flexible conductive material of the present invention and the method of manufacturing the same are as described above. Thus, the descriptions are omitted here. It is desirable to apply the preferred modes of the flexible conductive material of the present invention described above to the electrodes and the wirings of the transducer of the present invention. An actuator, a capacitance sensor, a power generating element, and a speaker are described below according to embodiments of the transducer of the present invention. An embodiment of the electrodes and the wirings of the present invention is also described in the embodiments below.

[First Embodiment]

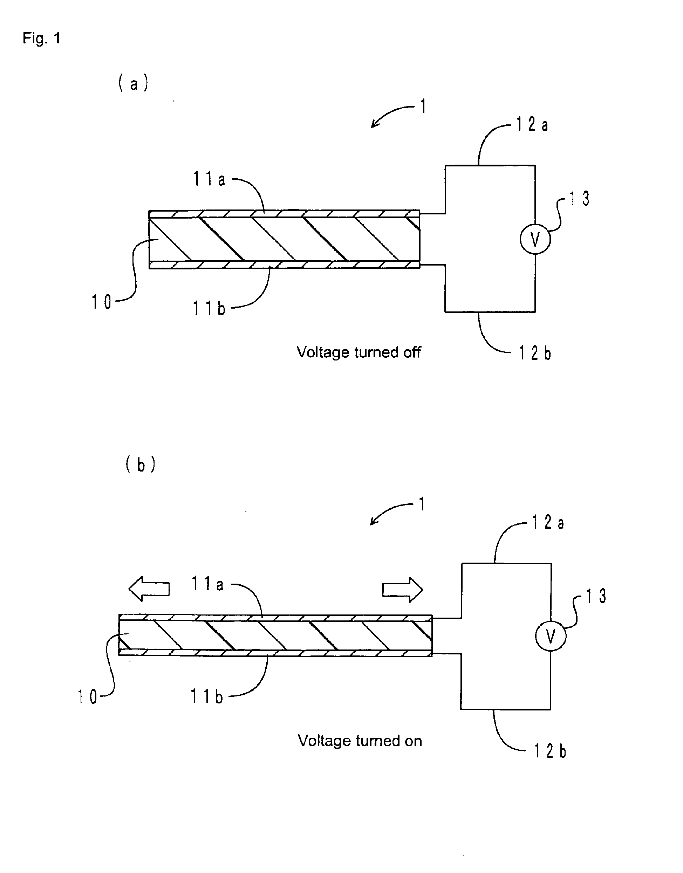

An actuator is described according to a first embodiment of the transducer of the present invention. Fig. 1 includes schematic cross-sectional views of the actuator according to the present embodiment, in which (a) illustrates a state where voltage is turned off and (b) illustrates a state where voltage is turned on.

With reference to Fig. 1, an actuator 1 has a dielectric film 10, electrodes 11a and 11b, and wirings 12a and 12b. The dielectric film 10 is composed of H-NBR. The electrode 11a is disposed so as to cover substantially an entire upper surface of the dielectric film 10. Similarly, the electrode 11b is disposed so as to cover substantially an entire lower surface of the dielectric film 10. The electrodes 11a and 11b are connected to a power source 13 through the wirings 12a and 12b, respectively. Both the electrodes 11a and 11b are formed of the flexible conductive material of the present invention.

To switch from off to on, a voltage is applied between the pair of electrodes 11a and 11b. With the voltage applied, the dielectric film 10 decreases in thickness and extends proportionately in a direction parallel to surfaces of the electrodes 11a and 11b, as indicated with white arrows in Fig. 1(b). Then, the actuator 1 outputs a driving force in an up/down direction and a left/right direction in the drawing.

According to the present embodiment, the electrodes 11a and 11b are flexible and expandable/contractable. Thus, the electrodes 11a and 11b can expand and contract to follow deformation of the dielectric film 10. In other words, the movement of the dielectric film 10 is hardly interfered with by the electrodes 11a and 11b. Thus, the actuator 1 achieves a larger force and displacement. Furthermore, the electrodes 11a and 11b hardly increase in electrical resistance even if repeatedly expanded and contracted. Accordingly, the actuator 1 hardly decreases in performance and thus has excellent durability. The actuator 1 is also excellent in responsiveness.

[Second Embodiment]

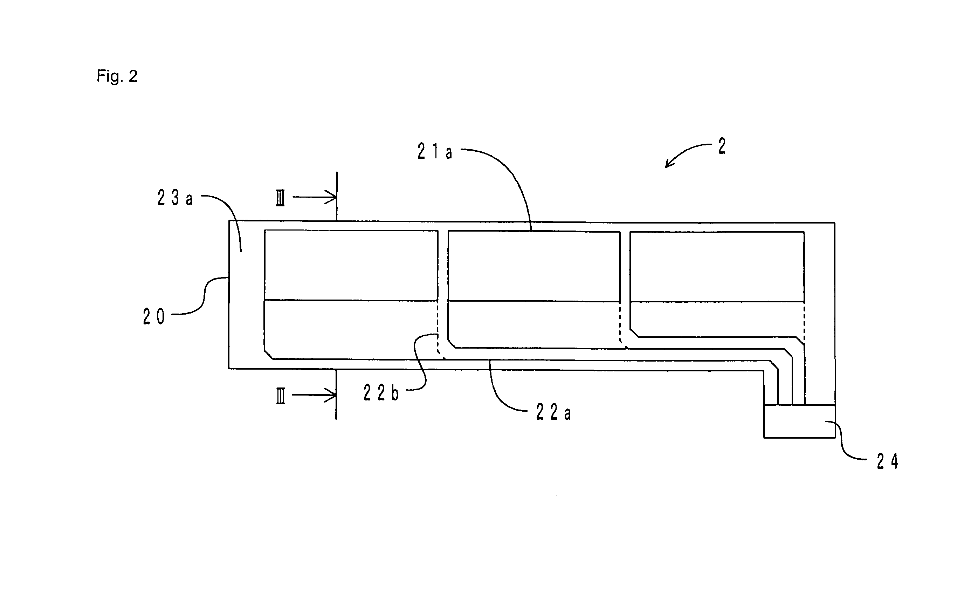

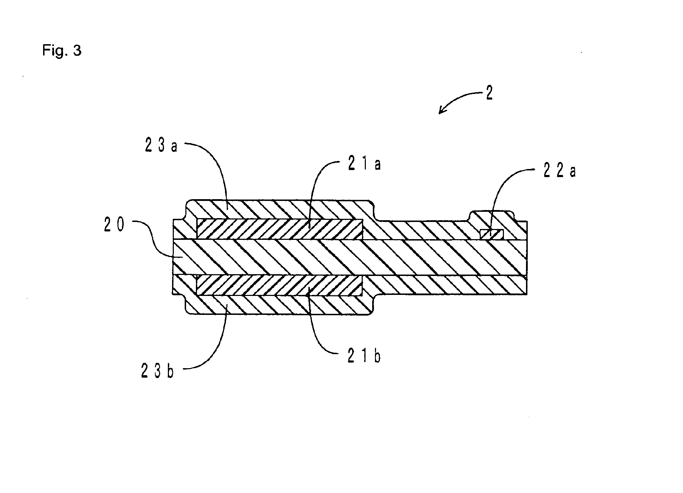

A capacitance sensor is described according to a second embodiment of the transducer of the present invention. A configuration of the capacitance sensor of the present embodiment is described first. Fig. 2 is a top view of the capacitance sensor. Fig. 3 is a cross-sectional view along a line III - III of Fig. 2. With reference to Figs. 2 and 3, a capacitance sensor 2 has a dielectric film 20, a pair of electrodes 21a and 21b, wirings 22a and 22b, and cover films 23a and 23b.

The dielectric film 20 is composed of H-NBR and has a band shape extending in the left/right direction. The dielectric film 20 has a thickness of approximately 300 μm.

The electrode 21a has a rectangular shape. The electrode 21a is screen printed on three portions of an upper surface of the dielectric film 20. Similarly, the electrode 21b has a rectangular shape. The electrode 21b is provided in three portions on a lower surface of the dielectric film 20 so as to be opposite to the electrode 21a with the dielectric film 20 therebetween. The electrode 21b is screen printed on the lower surface of the dielectric film 20. Thus, the electrodes 21a and 21b are provided in three pairs with the dielectric film 20 therebetween. The electrodes 21a and 21b are formed of the flexible conductive material of the present invention.

The wiring 22a is connected to each of the electrode 21a portions on the upper surface of the dielectric film 20. The wiring 22a connects the electrode 21a and a connector 24. The wiring 22a is screen printed on the upper surface of the dielectric film 20. Similarly, the wiring 22b is connected to each of the electrode 21b portions on the lower surface of the dielectric film 20 (indicated with a dotted line in Fig. 2). The wiring 22b connects the electrode 21b and a connector (not shown in the drawing). The wiring 22b is screen printed on the lower surface of the dielectric film 20. The wirings 22a and 22b are formed of the flexible conductive material of the present invention.

The cover film 23a is composed of acrylic rubber and has a band shape extending in the left/right direction. The cover film 23a covers upper surfaces of the dielectric film 20, the electrode 21a, and the wiring 22a. Similarly, the cover film 23b is composed of acrylic rubber and has a band shape extending in the left/right direction. The cover film 23b covers lower surfaces of the dielectric film 20, the electrode 21b, and the wiring 22b.

Operations of the capacitance sensor 2 are described below. The capacitance sensor 2 is pressed from above, for example, and then the dielectric film 20, the electrode 21a, and the cover film 23a are integrally bent downward. The compression reduces the thickness of the dielectric film 20. As a result, the capacitance between the electrodes 21 a and 21b increases. Deformation due to the compression is detected from the variation in capacitance.

Functions and effects of the capacitance sensor 2 according to the present embodiment are described below. The dielectric film 20, the electrodes 21a and 21b, the wirings 22a and 22b, and the cover films 23a and 23b are all composed of elastomer materials in the present embodiment. Thus, the entire capacitance sensor 2 is flexible and expandable/contractable. The electrodes 2 1 a and 21b and the wirings 22a and 22b can deform to follow deformation of the dielectric film 20. Furthermore, the electrodes 21a and 21b and the wirings 22a and 22b have high conductivity and hardly increase in electrical resistance even after repeated expansion and contraction. Thus, the capacitance sensor 2 has good responsiveness. In the capacitance sensor 2 of the present embodiment, the electrodes 21a and 21b are provided opposite each other in three pairs with the dielectric film 20 therebetween. However, the number, size, and placement of the electrodes may be determined appropriately depending on a purpose.

[Third Embodiment]

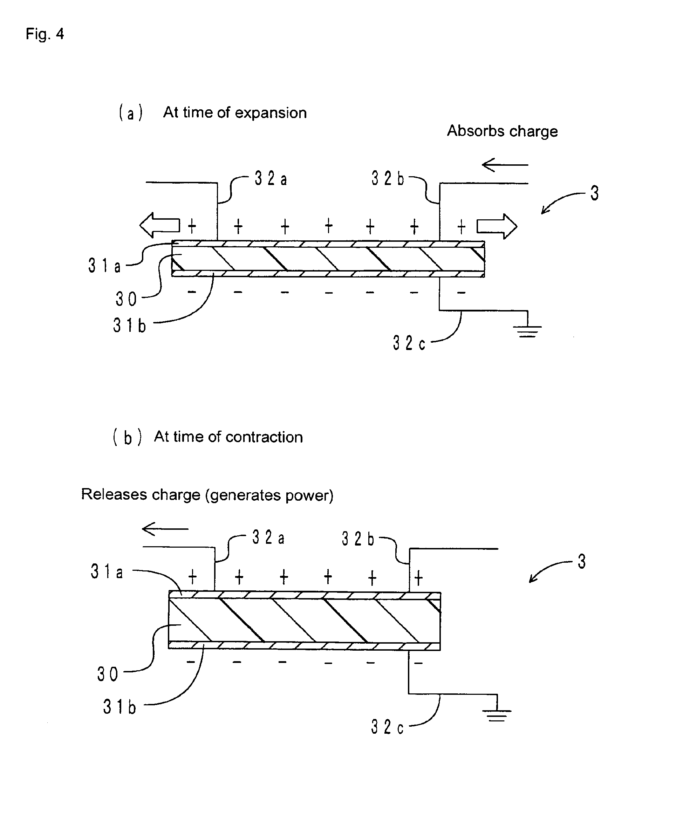

A power generating element is described according to a third embodiment of the transducer of the present invention. Fig. 4 includes schematic cross-sectional views of a power generating element according to the present embodiment, in which (a) illustrates the time of expansion and (b) illustrates the time of contraction.

With reference to Fig. 4, a power generating element 3 has a dielectric film 30, electrodes 31 a and 31b, and wirings 32a to 32c. The dielectric film 30 is composed of H-NBR. The electrode 31 a is disposed so as to cover substantially an entire upper surface of the dielectric film 30. Similarly, the electrode 31b is disposed so as to cover substantially an entire lower surface of the dielectric film 30. The wirings 32a and 32b are connected to the electrode 31a. Specifically, the electrode 31 a is connected to an external load (not shown in the drawing) through the wiring 32a. The electrode 31 a is connected to a power source (not shown in the drawing) through the wiring 32b. The electrode 31b is grounded through the wiring 32c. Both the electrodes 31a and 31b are formed of the flexible conductive material of the present invention.

The power generating element 3 is compressed and the dielectric film 30 is extended in parallel with surfaces of the electrodes 31a and 31b, as indicated with white arrows in Fig. 4(a). Then, the thickness of the dielectric film 30 is reduced and a charge is stored between the electrodes 31a and 31b. With removal of the compression force thereafter, the dielectric film 30 contracts due to elastic restoration force and increases in thickness, as shown in Fig. 4(b). At this time, the stored charge is discharged through the wiring 32a.

According to the present embodiment, the electrodes 31a and 31b are flexible and expandable/contractable.

Thus, the electrodes 31a and 31b can expand and contract to follow deformation of the dielectric film 30. In other words, the movement of the dielectric film 30 is hardly interfered with by the electrodes 31a and 31b. Furthermore, the electrodes 31a and 31b hardly increase in electrical resistance even when repeatedly expanded and contracted. Accordingly, the power generating element 3 hardly decreases in performance and thus has excellent durability.

[Fourth Embodiment]

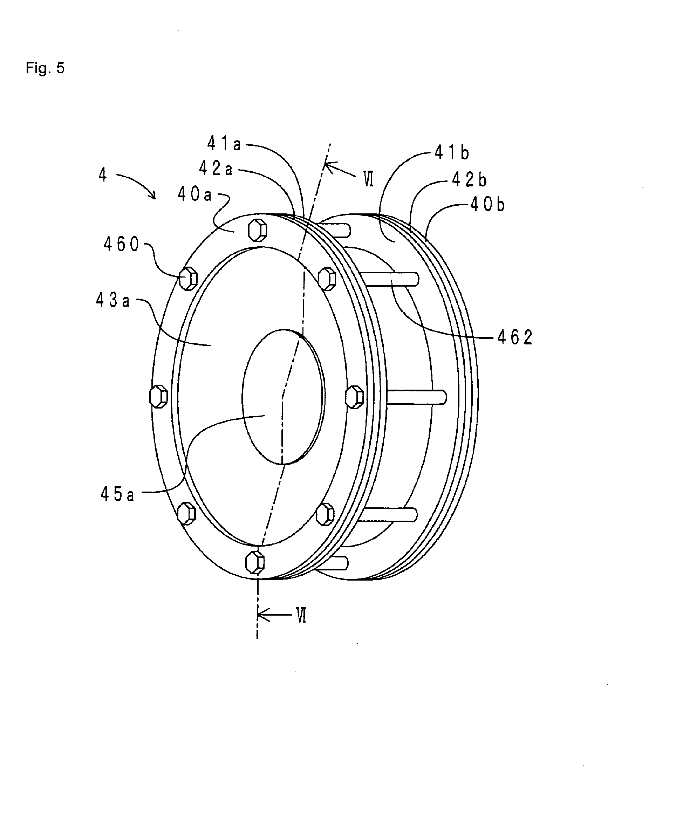

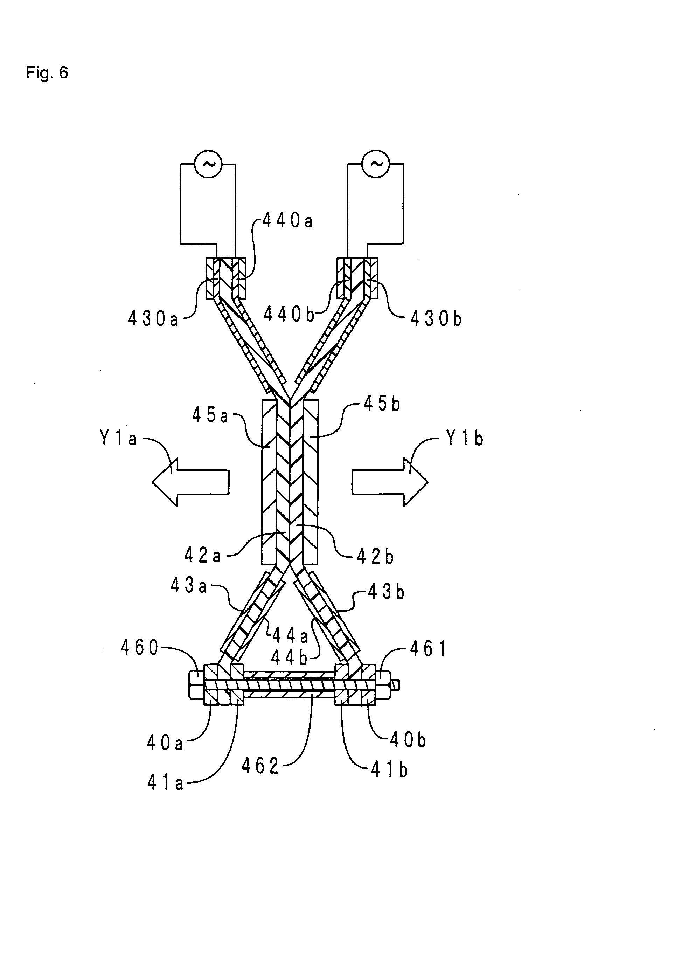

A speaker is described according to a fourth embodiment of the transducer of the present invention. A configuration of the speaker of the present embodiment is described first. Fig. 5 is a perspective view of the speaker according to the present embodiment. Fig. 6 is a cross-sectional view along a line VI - VI of Fig. 5. With reference to Figs. 5 and 6, a speaker 4 has a first outer frame 40a, a first inner frame 41a, a first dielectric film 42a, a first outer electrode 43a, a first inner electrode 44a, a first diaphragm 45a, a second outer frame 40b, a second inner frame 41b, a second dielectric film 42b, a second outer electrode 43b, a second inner electrode 44b, a second diaphragm 45b, eight bolts 460, eight nuts 461, and eight spacers 462.

The first outer frame 40a and the first inner frame 41a are each composed of a resin and have a ring shape. The first dielectric film 42a is composed of H-NBR and is a circular thin film. The first dielectric film 42a is stretched between the first outer frame 40a and the first inner frame 41a. Specifically, the first dielectric film 42a is held and fixed between the first outer frame 40a in the front and the first inner frame 41a in the rear in a state where a predetermined tension is ensured. The first diaphragm 45a is composed of a resin and has a circular plate shape. The first diaphragm 45a has a smaller diameter than the first dielectric film 42a. The first diaphragm 45a is disposed at substantially the center of the front surface of the first dielectric film 42a.

The first outer electrode 43a has a ring shape. The first outer electrode 43a is bonded to the front surface of the first dielectric film 42a. The first inner electrode 44a also has a ring shape. The first inner electrode 44a is bonded to the rear surface of the first dielectric film 42a. The first outer electrode 43a and the first inner electrode 44a are provided in reverse to each other in the front/rear direction with the first dielectric film 42a therebetween. Both the first outer electrode 43a and the first inner electrode 44a are formed of the flexible conductive material of the present invention. With reference to Fig. 6, the first outer electrode 43a has a terminal 430a. The first inner electrode 44a has a terminal 440a. A voltage is applied externally to the terminals 430a and 440a.

Configurations, materials, and shapes of the second outer frame 40b, the second inner frame 41b, the second dielectric film 42b, the second outer electrode 43b, the second inner electrode 44b, and the second diaphragm 45b (hereinafter collectively referred to as "second members") are similar to those of the first outer frame 40a, the first inner frame 41 a, the first dielectric film 42a, the first outer electrode 43a, the first inner electrode 44a, and the first diaphragm 45a (hereinafter collectively referred to as "first members"). The second members are disposed so as to be symmetric in the front/rear direction to the first members. Simply put, the second dielectric film 42b is composed of H-NBR and is stretched between the second outer frame 40b and the second inner frame 41b. The second diaphragm 45b is disposed at substantially the center of the front surface of the second dielectric film 42b. The second outer electrode 43b is printed on the front surface of the second dielectric film 42b. The second inner electrode 44b is printed on the rear surface of the second dielectric film 42b. Both the second outer electrode 43b and the second inner electrode 44b are formed of the flexible conductive material of the present invention. A voltage is applied externally to a terminal 430b of the second outer electrode 43b and a terminal 440b of the second inner electrode 44b.

The first members and the second members are fixed with the eight bolts 460 and the eight nuts 461 with the eight spacers 462 therebetween. Sets of the "bolt 460, nut 461, and spacer 462" are disposed in a circumferential direction of the speaker 4 at a predetermined distance. The bolt 460 passes from the front surface of the first outer frame 40a to the front surface of the second outer frame 40b. The nut 461 is screwed to a passed-through end portion of the bolt 460. The spacer 462 is composed of a resin and is annularly fitted to an axis of the bolt 460. The spacer 462 secures a predetermined distance between the first inner frame 41a and the second inner frame 41b. A central portion of the rear surface of the first dielectric film 42a (reverse surface to the surface on which the first diaphragm 45a is disposed) and a central portion of the rear surface of the second dielectric film 42b (reverse surface to the surface on which the second diaphragm 45b is disposed) are joined. Thus, a biasing force is accumulated in the first dielectric film 42a in a direction of a white arrow Y1a in Fig. 6. A biasing force is accumulated in the second dielectric film 42b in a direction of a white arrow Y1b in Fig. 6.

Operations of the speaker of the present embodiment are described below. In an initial state (offset state), a predetermined voltage (offset voltage) is applied to the first outer electrode 43a, the first inner electrode 44a, the second outer electrode 43b, and the second inner electrode 44b through the terminals 430a and 440a and the terminals 430b and 440b. When the speaker 4 is operated, an opposite-phase voltage is applied to the terminals 430a and 440a and the terminals 430b and 440b. With an offset voltage of+1V applied to the terminals 430a and 440a, for instance, the thickness reduces in a portion between the first outer electrode 43a and the first inner electrode 44a of the first dielectric film 42a. Furthermore, the portion extends in the diameter direction. Concurrently, an opposite-phase voltage (offset voltage of -1V) is applied to the terminals 430b and 440b. Then, the thickness increases in a portion between the second outer electrode 43b and the second inner electrode 44b of the second dielectric film 42a. Furthermore, the portion contracts in the diameter direction. Thus, the second dielectric film 42b elastically deforms due to a biasing force thereof in the direction of the white arrow Y1b in Fig. 6 while pulling the first dielectric film 42a. Conversely, with an offset voltage of+1V applied to the terminals 430b and 440b and an opposite-phase voltage (offset voltage of -1V) applied to the terminals 430a and 440a, the first dielectric film 42a elastically deforms due to a biasing force thereof in the direction of the white arrow Y1a in Fig. 6 while pulling the second dielectric film 42b. Thereby, the first diaphragm 45a and the second diaphragm 45b are vibrated to vibrate air and thus generate sound.

Functions and effects of the speaker 4 according to the present embodiment are described below. According to the present embodiment, the first outer electrode 43a, the first inner electrode 44a, the second outer electrode 43b, and the second inner electrode 44b (hereinafter referred to as "electrodes 43a, 44a, 43b, and 44b" when appropriate) are flexible and expandable/contractable. Thus, the first outer electrode 43a and the first inner electrode 44a can expand and contract to follow deformation of the first dielectric film 42a. Similarly, the second outer electrode 43b and the second inner electrode 44b can expand and contract to follow deformation of the second dielectric film 42b. In other words, the movements of the first dielectric film 42a and the second dielectric film 42b are hardly interfered with by the electrodes 43a, 44a, 43b, and 44b. Thus, the speaker 4 has good responsiveness even in a low frequency range. Furthermore, the electrodes 43a, 44a, 43b, and 44b hardly increase in electrical resistance even after repeated expansion and contraction. Accordingly, the speaker 4 hardly decreases in performance and thus has excellent durability.

<Electromagnetic Wave Shield>

An electromagnetic wave shield of the present invention is formed of the flexible conductive material of the present invention. The electromagnetic wave shield inhibits leaking of electromagnetic waves generated in an electronic device to an exterior and reduces intrusion of external electromagnetic waves into an interior. To provide the electromagnetic wave shield on an inner peripheral surface of a casing of an electronic device, for example, a conductive coating material for forming the flexible conductive material of the present invention can be applied to the inner peripheral surface of the casing of the electronic device and be dried. Furthermore, the electromagnetic wave shield can be provided to the capacitance sensor illustrated as the transducer according to the second embodiment. For instance, the electromagnetic wave shield can be disposed so as to cover the upper surface of the cover film 23a and the lower surface of the cover film 23b (refer to Figs. 2 and 3 above). In this case, the conductive coating material for forming the flexible conductive material of the present invention can be applied to the upper surface of the cover film 23a and the lower surface of the cover film 23b and be dried. To be disposed as a gasket between electronic devices, the flexible conductive material of the present invention can be formed into a desired shape.

Embodiments

The present invention is described more specifically in embodiments below.

<Producing Flexible Conductive Material>

[Embodiments 1 to 5]

First, an acrylic rubber polymer was produced through suspension polymerization of two kinds of monomers. The monomers were n-butyl acrylate (BA) and allylglycidylether (AGE). The monomers were mixed such that BA was 98 mass % and AGE was 2 mass %. A weight-average molecular weight of the produced acrylic rubber polymer measured with gel permeation chromatography (GPC) was approximately 800,000. A Tg of the acrylic rubber polymer was -45°C.

Subsequently, 400 parts by mass of silver powder A (Dowa Electronics Materials Co., Ltd.; product name: "FA-D-4"; flake shape; average grain size: 15 $\mu$m; aspect ratio: approximately 25) and 200 parts by mass of silver powder B (Dowa Electronics Materials Co., Ltd.; product name: "AG2-1C"; spherical shape; average grain size: 0.5 $\mu$m; aspect ratio: approximately 1) were mixed as conductive materials into 100 parts by mass of the produced acrylic rubber polymer. In addition, a predetermined amount of mercaptopropylmethoxysilane (Momentive Performance Materials Inc.; product name: "A-187") or trimercaptotriazine (Wako Pure Chemical Industries, Ltd.) was added as a reactive compound. Furthermore, 0.5 parts by mass of diaminodiphenyl methane (Wako Pure Chemical Industries, Ltd.) as an elastomer cross-linker was added as appropriate. Then, butoxyethyl acetate as a solvent was added. The viscosity was adjusted, and then the mixture was kneaded with a three-roll machine to prepare a conductive coating material.

Then, the prepared conductive coating material was coated on a surface of a base material formed of an acrylic resin in a bar-coating method. Thereafter, the base material on which the coating film was formed was rested for approximately 30 minutes in a drying oven at a temperature of approximately 150°C so as to dry the coating film and promote a cross-linking reaction. Thus, a flexible conductive material having a thin film shape was produced.

[Embodiments 6 to 8]

A flexible conductive material was produced in a similar manner to that of Embodiments 1 to 5 other than that a urethane rubber polymer was used instead of the acrylic rubber polymer. The urethane rubber polymer used was "Nipporan ® 5193" manufactured by Nippon Polyurethane Industry Co., Ltd. Mercaptopropylmethoxysilane (same as above) was used as a reactive compound. No elastomer cross-linker was mixed in.

[Embodiments 9 and 10]

A flexible conductive material was produced in a similar manner to that of Embodiment 1 other than that the type and composition amount of the conductive material and the composition amount of the reactive compound (mercaptopropylmethoxysilane) were changed. For the conductive material, 50 parts by mass of silver powder A (same as above), 50 parts by mass of silver powder B (same as above), and 300 parts by mass of silver powder C (Fukuda Metal Foil & Powder Co., Ltd.; product name: "ナノメルト ® AG-XF301"; flake shape; average grain size: 5 μm; aspect ratio: approximately 40) were used.

[Comparative Examples 1 and 2]

A flexible conductive material was produced in a similar manner to that of Embodiments 1 to 5 other than that the composition amount of the reactive compound was changed. Specifically, no reactive compound was mixed into the flexible conductive material of Comparative Example 1. In the flexible conductive material of Comparative Example 2, 0.86 parts by mass of mercaptopropylmethoxysilane was mixed in as the reactive compound.

[Comparative Examples 3 and 4]

A flexible conductive material was produced in a similar manner to that of Embodiments 6 to 8 other than that the composition amount of the reactive compound was changed. Specifically, no reactive compound was mixed into the flexible conductive material of Comparative Example 3. In the flexible conductive material of Comparative Example 4, 0.86 parts by mass of mercaptopropylmethoxysilane was mixed in as the reactive compound.

[Comparative Examples 5 and 6]

A flexible conductive material was produced in a similar manner to that of Embodiments 1 to 5 other than that butanethiol (Wako Pure Chemical Industries, Ltd.), which is not chemically bonded to an elastomer, was mixed in instead of the reactive compound. Specifically, 0.1 parts by mass of butanethiol was mixed into the flexible conductive material of Comparative Example 5; and 0.5 parts by mass of butanethiol was mixed into the flexible conductive material of Comparative Example 6.

<Calculating Coverage>

Research was conducted in advance with an Auger electron spectrometer on a relationship between the composition amount of the reactive compound or butanethiol and a covered area of the flexible conductive materials of the Embodiments and Comparative Examples. From the composition amount of the reactive compound or butanethiol used, coverage of the surface of the conductive material (silver powder) was calculated based on the formula (I) above. The reactive compounds used (two kinds) were both associated with a cross-linking reaction of the elastomer in addition to a bonding reaction between the elastomer and the conductive material. The coverage was calculated herein, however, based on an assumption that the reactive compounds were all used for the bonding reaction between the elastomer and the conductive material. In a case where the covered area exceeded the surface area of the conductive material from calculation due to a large composition amount of the reactive compound, the coverage was defined as 100%.

Table 1 illustrates a composition amount of raw materials, coverage, and film thickness of the flexible conductive materials of Embodiments 1 to 8. Table 2 illustrates a composition amount of raw materials, coverage, and film thickness of the flexible conductive materials of Comparative Examples 1 to 6. Table 3 illustrates a composition amount of raw materials, coverage, and film thickness of the flexible conductive materials of Embodiments 9 and 10. In Tables 1 to 3, a unit of the composition amount of raw materials is parts by mass.

[Table 1]

| | | | Embodiment 1 | Embodiment 2 | Embodiment 3 | Embodiment 4 | Embodiment 5 | Embodiment 6 | Embodiment 7 | Embodiment 8 |
|---|---|---|---|---|---|---|---|---|---|---|
| | | | | | | | | | | (Parts by mass) |
| Flexible conductive material | Elastomer | Acrylic rubber polymer | 100 | 100 | 100 | 100 | 100 | -- | -- | -- |
| | | Urethane rubber polymer | -- | -- | -- | -- | -- | 100 | 100 | 100 |
| | Conductive material | Silver powder A | 400 | 400 | 400 | 400 | 400 | 400 | 400 | 400 |
| | | Silver powder B | 200 | 200 | 200 | 200 | 200 | 200 | 200 | 200 |
| | Reactive compound | Mercaptopropylmethoxysilane | 0.086 | 0.086 | 0.172 | -- | -- | 0.086 | 0.129 | 0.043 |
| | | Trimercaptotriazine | -- | -- | -- | 0.01 | 0.02 | -- | -- | -- |
| | Elastomer cross-linker | Diaminodiphenylmethane | -- | 0.5 | 0.5 | 0.5 | 0.5 | -- | -- | -- |
| | Coverage of conductive material surface (%) | | 10 | 10 | 20 | 15 | 30 | 10 | 15 | 5 |
| | Film thickness ($\mu$m) | | 35 | 32 | 30 | 35 | 28 | 31 | 29 | 29 |
| Evaluation results | Volume resistivity in natural state ($\Omega \cdot$cm) | | $9.7 \times 10^{-5}$ | $1.5 \times 10^{-4}$ | $5.5 \times 10^{-4}$ | $3.4 \times 10^{-4}$ | $6.0 \times 10^{-4}$ | $8.1 \times 10^{-5}$ | $2.4 \times 10^{-4}$ | $8.0 \times 10^{-5}$ |
| | Volume resistivity in 10% expanded state ($\Omega \cdot$cm) | | $2.0 \times 10^{-4}$ | $2.2 \times 10^{-4}$ | $3.8 \times 10^{-3}$ | $4.5 \times 10^{-4}$ | $4.9 \times 10^{-3}$ | $1.0 \times 10^{-4}$ | $5.8 \times 10^{-4}$ | $1.8 \times 10^{-4}$ |
| | Resistive index (1,000 expansions/contractions) | | 5 | 5 | 9 | 10 | 17 | 8 | 22 | 68 |
| | Elasticity modulus (Mpa) | | 15 | 28 | 39 | 31 | 42 | 41 | 52 | 32 |
| | tan$\delta$ | | 0.78 | 0.76 | 0.60 | 0.74 | 0.65 | 0.44 | 0.39 | 0.46 |

[Table 2]

(Parts by mass)

| | | Comparative Example 1 | Comparative Example 2 | Comparative Example 3 | Comparative Example 4 | Comparative Example 5 | Comparative Example 6 |
|---|---|---|---|---|---|---|---|
| Flexible conductive material | Elastomer — Acrylic rubber polymer | 100 | 100 | -- | -- | 100 | 100 |
| | Elastomer — Urethane rubber polymer | -- | -- | 100 | 100 | -- | -- |
| | Conductive material — Silver powder A | 400 | 400 | 400 | 400 | 400 | 400 |
| | Conductive material — Silver powder B | 200 | 200 | 200 | 200 | 200 | 200 |
| | Reactive compound — Mercaptopropylmethoxysilane | -- | 0.86 | -- | 0.86 | -- | -- |
| | Reactive compound — Butanethiol | -- | -- | -- | -- | 0.1 | 0.5 |
| | Elastomer Diaminodiphenylmethane cross-linker | 0.5 | 0.5 | -- | -- | 0.5 | 0.5 |
| | Coverage of conductive material surface (%) | 0 | 100 | 0 | 100 | 10 | 50 |
| | Film thickness ($\mu$m) | 30 | 30 | 31 | 33 | 32 | 33 |
| | Volume resistivity in natural state ($\Omega \cdot$cm) | $1.5 \times 10^{-4}$ | $1.5 \times 10^{-3}$ | $7.5 \times 10^{-5}$ | $8.0 \times 10^{-4}$ | $7.4 \times 10^{-4}$ | $5.0 \times 10^{-3}$ |
| | Volume resistivity in 10% expanded state ($\Omega \cdot$cm) | $2.9 \times 10^{-4}$ | $2.9 \times 10^{-1}$ | $1.8 \times 10^{-4}$ | $3.9 \times 10^{-1}$ | $8.0 \times 10^{-3}$ | $9.4 \times 10^{-2}$ |
| Evaluation results | Resistive index (1,000 expansions/contractions) | 1780 | >$10^4$ | 2200 | >$10^4$ | >$10^4$ | >$10^4$ |
| | Elasticity modulus (Mpa) | 12 | 55 | 14 | 41 | 12 | 12 |
| | tan$\delta$ | 0.83 | 0.55 | 0.51 | 0.35 | 0.83 | 0.83 |

[Table 3]

| | | | Embodiment 9 | Embodiment 10 |
|---|---|---|---|---|
| | | | | (Parts by mass) |
| Flexible conductive material | Elastomer | Acrylic rubber polymer | 100 | 100 |
| | Conductive material | Silver powder A | 50 | 50 |
| | | Silver powder B | 50 | 50 |
| | | Silver powder C | 300 | 300 |
| | Reactive compound | Mercaptopropylmethoxysilane | 0.008 | 0.065 |
| | Coverage of conductive material surface (%) | | 0.5 | 4 |
| | Film thickness ($\mu$m) | | 104 | 88 |
| Evaluation results | Volume resistivity in natural state ($\Omega \cdot$cm) | | $5.0 \times 10^{-5}$ | $4.5 \times 10^{-5}$ |
| | Volume resistivity in 10% expanded state ($\Omega \cdot$cm) | | $2.5 \times 10^{-4}$ | $2.2 \times 10^{-4}$ |
| | Volume resistivity in 50% expanded state ($\Omega \cdot$cm) | | $1.9 \times 10^{-3}$ | $3.3 \times 10^{-3}$ |
| | Resistive index (2,000 expansions/contractions) | | 4 | 4 |
| | Elasticity modulus (Mpa) | | 80 | 95 |

<Evaluation Method>

The flexible conductive materials of the Embodiments and Comparative Examples were evaluated for flexibility and conductivity. Furthermore, a loss coefficient (tan $\delta$ was obtained, which is a reference to determine whether or not a conductive material is incorporated into a mesh structure of an elastomer. Evaluation methods thereof are described below.

[Flexibility]

A tensile test pursuant to JIS K7127 (1999) was conducted on the flexible conductive materials. A shape of a test piece was test piece type 2. From an obtained stress-stretch curve, an elasticity modulus was calculated for the flexible conductive material.

[Conductivity]

(1) Volume resistivity of the flexible conductive materials was measured by the parallel plate electrode method of JIS K6271 (2008). In the measurement, a commercially-available silicone rubber sheet (Kureha Elastomer Co., Ltd.) was used as a support formed of an insulating resin to support the flexible conductive material (test piece). The volume resistivity was measured in two types, with and without expansion. Specifically, the measurement was performed in a natural state (no expansion) and in a state of expansion at an expansion rate of 10% in one axis direction (hereinafter referred to as "10% expanded state" when appropriate). In addition, the measurement was performed in a state of expansion at an expansion rate of 50% in one axis direction (hereinafter referred to as "50% expanded state" when appropriate) on the flexible conductive materials of Embodiments 9 and 10. The expansion rate herein is calculated in the following formula (II):

$$\text{Expansion rate (\%)} = (\Delta L_0 / L_0) \times 100 \text{ ... (II)}$$

[$L_0$: Gauge length of a test piece; $\Delta L_0$: Increase due to expansion in the gauge length of the test piece]
(2) The flexible conductive material was repeatedly expanded and contracted. A change in the volume resistivity was measured before and after the expansion and contraction. The flexible conductive material was expanded and contracted at a frequency of 1 Hz such that the flexible conductive material was in the natural state → 10% expanded state → natural state. With the "natural state → 10% expanded state → natural state" counted as one time, the expansion and contraction was performed consecutively 1,000 times (the expansion and contraction was performed 2,000 times only for the flexible conductive materials of Embodiments 9 and 10). After the first expansion and contraction, the flexible conductive material was expanded at an expansion rate of 10% and the volume resistivity was measured. Furthermore, after the expansion and contraction was repeated 1,000 times, the flexible conductive material was similarly expanded at an expansion rate of 10% and the volume resistivity was measured. Then, a resistive index was calculated in the formula (III) below. The smaller the resistive index is, the less an increase in electrical resistance is after the repeated expansion and contraction.

$$\text{Resistive index} = \text{Volume resistivity in the 10\% expanded state after 1,000 expansions and contractions} / \text{Volume resistivity in the 10\% expanded state after one expansion and contraction} \dots (III)$$

[Loss Coefficient (tan δ)]

Dynamic viscoelasticity was measured in a temperature range from -30°C to 80°C in a case where the flexible conductive material was tensile strained, and then a peak value of a loss coefficient (tan δ) was obtained. The dynamic viscoelasticity was measured with a dynamic viscoelasticity measurement device (UBM "Rheogel-E4000").

<Evaluation Results>

Results of evaluation of the flexible conductive materials of the Embodiments and Comparative Examples are collectively shown in Tables 1 to 3 above. As demonstrated in Tables 1 and 3, the flexible conductive materials of the Embodiments were all flexible with a low elasticity modulus. Furthermore, all the flexible conductive materials of the Embodiments had high conductivity in the natural state. The volume resistivity in the 10% expanded state for all was $1 \times 10^{-2}$ Ω·cm or less. In other words, an increase in the electrical resistance was small even after expansion by 10%. In particular, the volume resistivity in the 50% expanded state was also $1 \times 10^{-2}$ Ω·cm or less in the flexible conductive materials of Embodiments 9 and 10. In other words, an increase in the electrical resistance was small even after expansion by 50%. The flexible conductive material of Embodiment 9 achieved high conductivity despite a small composition amount of the reactive compound and a small coverage of 0.5%. With a low resistive index, the flexible conductive materials of the Embodiments were demonstrated to hardly increase in electrical resistance even after repeated expansion and contraction.

Comparisons are performed below between Embodiments 1 to 3 and Comparative Examples 1 and 2, in which the same elastomer and reactive compound were used. As demonstrated in Tables 1 and 2, the resistive index was high in the flexible conductive material of Comparative Example 1 that included no reactive compound. In contrast, the resistive index was substantially reduced in the flexible conductive materials of Embodiments 1 to 3. In other words, an increase in the electrical resistance was small even after repeated expansion and contraction. This is because chemical bonding between the conductive material and the elastomer inhibited the conductive material from peeling from the elastomer and inhibited the conductive material from moving. In addition, the tan δ of the flexible conductive materials of Embodiments 1 to 3 was less by 0.05 or greater than that of the flexible conductive material of Comparative Example 1. Thus, the conductive material was confirmed to be incorporated in the mesh structure of the elastomer in the flexible conductive materials of Embodiments 1 to 3. Conversely, the volume resistivity in the 10% expanded state was high and the resistive index was extremely high in the flexible conductive material of Comparative Example 2 which had a large composition amount of the reactive compound (coverage of 100%). The flexible conductive material of Comparative Example 2 having a large coverage had a small contact area between the surfaces of the conductive materials themselves. Thus, a conductive path was easily disconnected due to expansion, and thus the electrical resistance increased.

Similar observations apply in comparison between Embodiments 6 to 8 and Comparative Examples 3 and 4. Specifically, the resistive index was high in the flexible conductive material of Comparative Example 3 which included no resistive compound. In contrast, the resistive index reduced substantially in the flexible conductive materials of Embodiments 6 to 8. In other words, an increase in the electrical resistance was small even after repeated expansion and contraction. The tan δ of the flexible conductive materials of Embodiments 6 to 8 was less by 0.05 or greater than that of the flexible conductive material of Comparative Example 3. Thus, the conductive material was confirmed to be incorporated in the mesh structure of the elastomer in the flexible conductive materials of Embodiments 6 to 8. Conversely, the volume resistivity in the 10% expanded state was high and the resistive index was extremely high in the flexible conductive material of Comparative Example 4 which had a large composition amount of the reactive compound (coverage of 100%).

Compared with the flexible conductive materials of Embodiments 6 and 7, the resistive index was relatively high in the flexible conductive material of Embodiment 8. This is because, compared with the flexible conductive materials of Embodiments 6 and 7, the conductive material was not able to be sufficiently chemically bonded to the elastomer in the flexible conductive material of Embodiment 8, which had a small composition amount of the reactive compound. Thus, the reactive compound exists in an optimum composition amount for reduction of the resistive index. In other words, optimizing the composition amount of the reactive compound can reduce the resistive index.

The tan $\delta$ of the flexible conductive materials of Comparative Examples 5 and 6 which included butanethiol did not change, compared to the flexible conductive material of Comparative Example 1. Butanethiol, which is a sulfur compound, is not chemically bonded to the elastomer and is chemically bonded only to the conductive material. Thus, the conductive material was not incorporated into the mesh structure of the elastomer. Accordingly, the resistive index was extremely high in the flexible conductive materials of Comparative Examples 5 and 6.

As described above, the flexible conductive material having high capacity for expansion/contraction and high conductivity that hardly increases in electrical resistance even after repeated expansion and contraction is achieved by chemically bonding the conductive material and the elastomer at a predetermined coverage.

[Industrial Applicability]

The flexible conductive material according to the present invention is suitable as an electrode and a wiring of a flexible transducer composed of an elastomer. Furthermore, it is also suitable as an electromagnetic wave shield and a conductive adhesive agent. In addition, it is suitable as a wiring of a flexible wiring board used for control of a movable portion of a robot or an industrial machine, for a wearable device, and for a bendable display.

**Claims**

1. A flexible conductive material comprising:

   an elastomer; and
   a conductive material comprising silver at least in a surface, wherein
   the conductive material is chemically bonded to the elastomer directly or indirectly and is thus incorporated into a mesh structure of the elastomer, and
   volume resistivity in a case of expansion by 10% in one axis direction is $1 \times 10^{-2}$ $\Omega \cdot$cm or less.

2. The flexible conductive material according to claim 1, further comprising:

   a reactive compound capable of being chemically bonded to both the elastomer and the conductive material.

3. The flexible conductive material according to claim 2, wherein the reactive compound comprises a sulfur compound.

4. The flexible conductive material according to one of claims 1 to 3, wherein the volume resistivity in a case of expansion by 50% in one axis direction is $1 \times 10^{-2}$ $\Omega \cdot$cm or less.

5. The flexible conductive material according to one of claims 1 to 4, wherein the elastomer has a functional group capable of being chemically bonded to the conductive material.

6. The flexible conductive material according to claim 5, wherein the functional group comprises at least one kind selected from a fluorine atom, a chlorine atom, and a sulfur atom.

7. The flexible conductive material according to one of claims 1 to 6, wherein coverage of the surface of the conductive material by at least one of the elastomer and the reactive compound is 0.5% or greater and 40% or less.

8. The flexible conductive material according to one of claims 1 to 7, further comprising:

   an elastomer cross-linker not chemically bonded to the conductive material.

9. The flexible conductive material according to one of claims 1 to 8, wherein the elastomer is at least one kind selected from a cross-linked rubber cross-linked without an organic peroxide and a thermoplastic elastomer.

10. The flexible conductive material according to one of claims 1 to 9, wherein the flexible conductive material is disposed on a surface of an elastic member.

11. The flexible conductive material according to claim 10, wherein the elastic member comprises an elastomer and the elastomer is at least one kind selected from a cross-linked rubber cross-linked without any of sulfur, a sulfur compound, and an organic peroxide and a thermoplastic elastomer.

12. A method of manufacturing the flexible conductive material according to claim 1, the method comprising:

preparing a rubber composition comprising a rubber polymer comprising the elastomer component, the conductive material, and a reactive compound capable of being chemically bonded to both the elastomer and the conductive material and mixed when necessary; and
cross-linking the prepared rubber composition.

13. The method of manufacturing the flexible conductive material according to claim 12, wherein preparing the rubber composition comprises:

pre-treating to allow the conductive material and the reactive compound to react with each other in advance; and
mixing the chemically bonded conductive material and reactive compound with the rubber polymer.

14. An electrode comprising the flexible conductive material according to one of claims 1 to 11.

15. A wiring comprising the flexible conductive material according to one of claims 1 to 11.

16. An electromagnetic wave shield comprising the flexible conductive material according to one of claims 1 to 11.

17. A transducer comprising:

a dielectric film comprising one of an elastomer and a resin;
a plurality of electrodes disposed with the dielectric film therebetween; and
a wiring connected to each of the plurality of electrodes, wherein
at least one of the electrodes and the wirings comprise the flexible conductive material according to one of claims 1 to 11.

**Amended claims under Art. 19.1 PCT**

1. (Amended) A flexible conductive material comprising:

an elastomer; and
a conductive material comprising silver at least in a surface, wherein
the conductive material is chemically bonded to the elastomer directly or indirectly and is thus incorporated into a mesh structure of the elastomer, and
volume resistivity <u>in a state of expansion</u> by 10% in one axis direction is $1 \times 10^{-2}$ $\Omega \cdot$cm or less.

2. The flexible conductive material according to claim 1, further comprising:

a reactive compound capable of being chemically bonded to both the elastomer and the conductive material.

3. The flexible conductive material according to claim 2, wherein the reactive compound comprises a sulfur compound.

4. (Amended) The flexible conductive material according to one of claims 1 to 3, wherein the volume resistivity <u>in a state of expansion</u> by 50% in one axis direction is $1 \times 10^{-2}$ $\Omega \cdot$cm or less.

5. The flexible conductive material according to one of claims 1 to 4, wherein the elastomer has a functional group capable of being chemically bonded to the conductive material.

6. The flexible conductive material according to claim 5, wherein the functional group comprises at least one kind selected from a fluorine atom, a chlorine atom, and a sulfur atom.

**7.** The flexible conductive material according to one of claims 1 to 6, wherein coverage of the surface of the conductive material by at least one of the elastomer and the reactive compound is 0.5% or greater and 40% or less.

**8.** The flexible conductive material according to one of claims 1 to 7, further comprising:

an elastomer cross-linker not chemically bonded to the conductive material.

**9.** The flexible conductive material according to one of claims 1 to 8, wherein the elastomer is at least one kind selected from a cross-linked rubber cross-linked without an organic peroxide and a thermoplastic elastomer.

**10.** The flexible conductive material according to one of claims 1 to 9, wherein the flexible conductive material is disposed on a surface of an elastic member.

**11.** The flexible conductive material according to claim 10, wherein the elastic member comprises an elastomer and the elastomer is at least one kind selected from a cross-linked rubber cross-linked without any of sulfur, a sulfur compound, and an organic peroxide and a thermoplastic elastomer.

**12.** A method of manufacturing the flexible conductive material according to claim 1, the method comprising:

preparing a rubber composition comprising a rubber polymer comprising the elastomer component, the conductive material, and a reactive compound capable of being chemically bonded to both the elastomer and the conductive material and mixed when necessary; and
cross-linking the prepared rubber composition.

**13.** The method of manufacturing the flexible conductive material according to claim 12, wherein preparing the rubber composition comprises:

pre-treating to allow the conductive material and the reactive compound to react with each other in advance; and
mixing the chemically bonded conductive material and reactive compound with the rubber polymer.

**14.** An electrode comprising the flexible conductive material according to one of claims 1 to 11.

**15.** A wiring comprising the flexible conductive material according to one of claims 1 to 11.

**16.** An electromagnetic wave shield comprising the flexible conductive material according to one of claims 1 to 11.

**17.** A transducer comprising:

a dielectric film comprising one of an elastomer and a resin;
a plurality of electrodes disposed with the dielectric film therebetween; and
a wiring connected to each of the plurality of electrodes, wherein
at least one of the electrodes and the wirings comprise the flexible conductive material according to one of claims 1 to 11.

**Statement under Art. 19.1 PCT**

With the amendment to claim 1 of the Scope of Claims, it is clarified that the value of volume resistivity, which is $1 \times 10^{\square 2}$ $\Omega \cdot$cm or less, is measured in a state where the flexible conductive material of the present invention is expanded by 10% in one axis direction. Similarly, with the amendment to claim 4 of the Scope of Claims, it is clarified that the value of volume resistivity, which is $1 \times 10^{\square 2}$ $\Omega \cdot$cm or less, is measured in a state where the flexible conductive material of the present invention is expanded by 50% in one axis direction. An increase in electrical resistance is small in the flexible conductive material of the present invention in a state of expansion. Furthermore, a decrease in conductivity is small even after repeated expansion and contraction.

In contrast, Literature 1 (JP2002-212426A) discloses a conductive silicone rubber composition having a volume resistivity of $1 \times 10^{\square 5}$ $\Omega \cdot$cm or less in a hardened form and a ratio of volume resistivity of 100 or less between an initial state and a state restored from expansion by 50%. In Literature 1, the volume resistivity is measured after a hardened form of the conductive silicone rubber composition is restored once expanded, but not in a state where the hardened form is expanded. Literature 1 includes no description of chemical bonding between a conductive material and an elastomer in the hardened form of the conductive silicone rubber composition nor of the volume resistivity in the state of expansion.

Fig. 1

( a )

Voltage turned off

( b )

Voltage turned on

EP 2 568 778 A1

Fig. 2

23

Fig. 3

Fig. 4

( a )   At time of expansion

Absorbs charge

31a
30
31b
32a
32b
32c
3

( b )   At time of contraction

Releases charge (generates power)

31a
30
31b
32a
32b
32c
3

Fig. 5

Fig. 6

**INTERNATIONAL SEARCH REPORT**

| International application No. |
| --- |
| PCT/JP2012/052974 |

A. CLASSIFICATION OF SUBJECT MATTER
*H05K1/09*(2006.01)i, *C08K3/08*(2006.01)i, *C08K9/02*(2006.01)i, *C08L21/00* (2006.01)i, *H02N2/00*(2006.01)i

According to International Patent Classification (IPC) or to both national classification and IPC

B. FIELDS SEARCHED

Minimum documentation searched (classification system followed by classification symbols)
H05K1/09, C08K3/08, C08K9/02, C08L21/00, H02N2/00

Documentation searched other than minimum documentation to the extent that such documents are included in the fields searched
Jitsuyo Shinan Koho          1922-1996     Jitsuyo Shinan Toroku Koho     1996-2012
Kokai Jitsuyo Shinan Koho    1971-2012     Toroku Jitsuyo Shinan Koho     1994-2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2002-212426 A (Shin-Etsu Chemical Co., Ltd.), | 1,4-6,8-9, 14-16 |
| Y | 31 July 2002 (31.07.2002), paragraphs [0010] to [0030] (Family: none) | 2-3,7,10-13, 17 |
| Y | JP 2001-229731 A (Sumitomo Metal Mining Co., Ltd.), 24 August 2001 (24.08.2001), paragraph [0073] & US 2003/0165616 A1      & US 2003/0170448 A1 & EP 1079413 A3         & EP 1079413 A2 & DE 60023614 D         & DE 60023614 T & TW 235757 B            & KR 10-2001-0030136 A | 2-3,7,12-13 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 04 April, 2012 (04.04.12) | 17 April, 2012 (17.04.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

<table>
<tr><td colspan="2" style="text-align:center"><strong>INTERNATIONAL SEARCH REPORT</strong></td><td>International application No.<br>PCT/JP2012/052974</td></tr>
</table>

**C (Continuation). DOCUMENTS CONSIDERED TO BE RELEVANT**

| Category* | Citation of document, with indication, where appropriate, of the relevant passages | Relevant to claim No. |
|---|---|---|
| Y | JP 5-151853 A (Shinano Polymer Co., Ltd.), 18 June 1993 (18.06.1993), paragraphs [0012] to [0013] (Family: none) | 2-3,7,12-13 |
| Y | JP 2009-59856 A (Tokai Rubber Industries, Ltd.), 19 March 2009 (19.03.2009), paragraphs [0007] to [0017] (Family: none) | 10-11 |
| Y | WO 2011/001910 A1 (Tokai Rubber Industries, Ltd.), 06 January 2011 (06.01.2011), paragraph [0035] (Family: none) | 17 |
| A | JP 2004-27087 A (Shin-Etsu Chemical Co., Ltd.), 29 January 2004 (29.01.2004), entire text (Family: none) | 1-17 |
| A | JP 2002-60625 A (Shin-Etsu Chemical Co., Ltd.), 26 February 2002 (26.02.2002), entire text & US 2002/0049274 A1 | 1-17 |
| A | JP 11-350002 A (Dow Corning Toray Silicone Co., Ltd.), 21 December 1999 (21.12.1999), entire text (Family: none) | 1-17 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009124839 A
- JP 2010153364 A
- JP 2007073267 A